# EUROPÄISCHE PATENTSCHRIFT

(11) **EP 4 436 909 B1**
(45) Veröffentlichungstag und Bekanntmachung des Hinweises auf die Patenterteilung: **10.12.2025**
(21) Anmeldenummer: 22809095.7
(22) Anmeldetag: 25.10.2022
(51) Int. Cl.: B81B 3/00, B81C 1/00

(54) **VERFAHREN ZUR HERSTELLUNG EINER STRUKTUR FÜR MIKROELEKTROMECHANISCHE SYSTEME**
METHOD FOR PRODUCING A STRUCTURE FOR MICRO-ELECTROMECHANICAL SYSTEMS
PROCÉDÉ DE PRODUCTION D'UNE STRUCTURE POUR SYSTÈMES MICRO-ÉLECTROMÉCANIQUES

(30) Priorität: 26.11.2021 DE 102021131084
(43) Veröffentlichungstag der Anmeldung: 02.10.2024
(73) Patentinhaber: LPKF Laser & Electronics SE, 30827 Garbsen (DE)
(72) Erfinder: OSTHOLT, Roman, 30855 Langenhagen (DE); AMBROSIUS, Norbert, 30827 Garbsen (DE); BERTKE, Maik, 30161 Hannover (DE)
(74) Vertreter: Scheffler, Jörg
(86) Internationale Anmeldenummer: PCT/EP2022/079749
(87) Internationale Veröffentlichungsnummer: WO 2023/094094

(56) Entgegenhaltungen:
- JP-A- 2018 094 661
- US-A1- 2015 279 587

## Beschreibung

Die Erfindung betrifft ein zur Herstellung einer Struktur insbesondere aus Glas für mikroelektromechanische Systeme (MEMS) bestimmtes Verfahren, insbesondere eines als ein elektrostatischer Mikroaktuator ausgeführten MEMS-Aktors. Weiterhin betrifft die Erfindung ein nach dem Verfahren hergestelltes mikroelektromechanisches System.

Unter der Bezeichnung MEMS sind mikroelektromechanische Systeme, insbesondere also Bauteile mit Abmessungen in der Größenordnung von einigen Mikrometern bis zu mehreren Millimetern bekannt geworden, die elektrische und mechanische Komponenten vereinigen, wobei sich die inneren Strukturgrößen im Bereich von wenigen Nanometern bis hundert Mikrometern bewegen.

Bei der Herstellung solcher Mikrosysteme ist das Kontrollieren und Einstellen von mechanischen Spannungen der Strukturen für die Qualität, Stabilität und Funktionalität der entsprechenden Schaltungen oder Systeme von wesentlicher Bedeutung.

Bei den meisten Anwendungen ist es wünschenswert, wenn die Strukturen sowie die Schichten auf dem Substrat möglichst frei von mechanischen Spannungen sind. Zu hohe mechanische Spannungen in den Strukturen können zu verschiedenen Problemen führen, wie beispielsweise schlechte Haftung einzelner Schichten auf den unterliegenden Materialien.

Durch die Abscheidung von Beschichtungen auf der Struktur entstehen üblicherweise unabhängig von den Auftragsverfahren mechanische Spannungen in den oberflächennahen Schichten als Zugspannungen und Druckspannungen. Grundsätzlich führt eine Schicht mit Zugspannung zu einer konkaven und eine Schicht mit Druckspannung zu einer konvexen Verformung der Struktur.

Es ist auch bekannt, die Spannungen innerhalb der Schichten zur Unterstützung bestimmter Eigenschaften zu nutzen. Beispielsweise sind Versuche bekannt geworden, mechanische Spannungen in den Membranen von kapazitiven Drucksensoren so einzustellen, dass die Membranen unter dem Atmosphärendruck einem gebogenen Verlauf folgen.

Neben den mechanischen Spannungen, die aufgrund von unterschiedlichen Wärmeausdehnungskoeffizienten des Substrats als thermische Spannungen entstehen, werden die Spannungen, die von Morphologieveränderungen innerhalb der Schicht verursacht werden, als intrinsische Spannungen bezeichnet.

Zur Verbesserung der Widerstandsfähigkeit von Glas, insbesondere zur Verwendung bei Displays, sind Ionenaustauschverfahren zur Herstellung einer gehärteten Oberfläche bekannt. Dabei dringen in einer Schmelze Kaliumionen in die Glasoberfläche ein und ersetzen die ursprünglich im Glas enthaltenen kleineren Natriumionen. Bei der Abkühlung des Glases treten durch die größeren Kaliumionen Kompressionen auf, sodass eine Druckspannungsschicht erzeugt wird, welche die widerstandsfähige Oberfläche bildet.

Bei einem Verfahren zur Herstellung eines Glasgegenstands gemäß der DE 10 2017 008 610 A1 dient das chemische Härten von Glas der Vermeidung einer Verformung.

Aus der US 2020 / 095 163 A1 ist ein Verfahren zur Herstellung eines Gegenstands aus Dünnglas für die Verwendung in elektronischen Geräten und als optisches Gerät bekannt, bei dem das Verfahren eine lonenaustauschbehandlung umfasst. Dabei wird durch das vollständige oder teilweise Maskieren von Bereichen der Außenfläche eine ungleichmäßige lonenaustauschbehandlung erreicht. In dem Dünnglas kann so aufgrund der Oberflächendruckspannung, die aus der ungleichmäßigen lonenaustauschbehandlung resultiert, eine Krümmung induziert werden, sodass das Dünnglas in eine gebogene Form gebracht und in dieser Konfiguration fixiert werden kann.

Der Erfindung liegt die Aufgabe zugrunde, ein Verfahren zur Herstellung einer Struktur gemäß Anspruch 1 sowie ein Struktur gemäß Anspruch 7 bereitzustellen.

Im Gegensatz zu dem Stand der Technik, bei dem die Spannungen innerhalb der Struktur dazu genutzt werden, die Oberfläche zu härten und darüber hinaus zugleich auch einer Verformung entgegenzuwirken, macht sich die Erfindung die überraschende Erkenntnis zu Nutze, dass durch eine gezielte Veränderung der Oberfläche durch Strukturierungen oder Abdeckungen die dadurch in den gegenüberliegenden Außenseiten ungleichmäßig bzw. asymmetrisch wirkenden Druckspannungen oder Zugspannungen eine gezielte Verformung, insbesondere auch durch Einstellung des örtlichen Verformungsgrads erreicht werden kann, um so ganz allgemein plastisch verformte, unebene Strukturen zu erzeugen. Diese verformten Strukturen lassen sich nach der Verformung im Rahmen der ursprünglichen Materialeigenschaften elastisch verformen, beispielsweise also eine Ausformung als Funktionsträger auslenken, sodass sich die so erzeugten Strukturen optimal für MEMS-Aktoren eignen.

Mit anderen Worten bezieht sich die Erfindung auf die Herstellung eines solchen Funktionselements, insbesondere auf das Einbringen einer entsprechenden Vorspannung zur Erzeugung einer gebogenen Grundform.

Ein Anwendungsbeispiel ist die Kontaktierung von Oberflächen, beispielsweise von metallischen Schaltkontakten. Hierzu wird in das zunächst ebene, streifenförmige Substrat der Struktur einseitig oder beidseitig eine partielle oder vollflächige Strukturierung eingebracht, die eine Oberflächenvergrößerung oder durch eine Abdeckung, also eine Schicht zur Passivierung gegenüber der nachfolgenden Behandlung, beispielsweise einem Ionenaustausch, eine Reduzierung der Oberfläche einer ersten Außenseite im Verhältnis zu der gegenüberliegenden zweiten Außenseite zur Folge hat.

Erfindungsgemäß wird die Behandlung, die vorzugsweise einen Ionenaustausch umfasst, zum Zwecke der Verformung, insbesondere also zum Einbringen einer Wölbung, Abwinkelung oder Abbiegung aus der Ebene des ursprünglich ebenen Substrats heraus genutzt. Dadurch können gezielt 3D-Konturen in dem Glas bzw. entsprechende Strukturen erzeugt werden, wobei die weiteren Eigenschaften nahezu unverändert erhalten bleiben.

Zum Verständnis der Erfindung ist die Erkenntnis, dass die eingebrachten Druck- oder Zugspannungen nicht nur von der bloßen Fläche der durch die Strukturierung vergrößerten Oberfläche abhängen, sondern auch von deren Richtung. Dieser Effekt ist dem Fachmann aus dem Bereich der Glashärtung von Displays an sich bekannt. Vereinfacht dargestellt wirken sich die Strukturierungen nur dann aus, wenn diese zu einer effektiven Vergrößerung der Oberflächenbereiche in Richtung der Haupterstreckung der zu verformenden Struktur, insbesondere der Ausformung, verlaufen. Bei nutenförmigen Längsschnitten entstehen so zusätzlich zu der verbleibenden Oberfläche auch die Fläche in dem Nutengrund und zusätzlich auch die Wandfläche, die ebenfalls in Richtung der Haupterstreckung orientiert ist. Die Druck- oder Zugspannungen werden dementsprechend durch Längsschnitte erhöht. Umgekehrt führen Schnitte in Querrichtung zu einem gegenteiligen Effekt, da die Wandflächen in Querrichtung zu der Haupterstreckung orientiert sind. Zudem sind die Druck- oder Zugspannungen im Bereich der äußeren Oberfläche des Substrats in ihrer Wirkung durch die in Querrichtung verlaufenden Schnitte reduziert, sodass die Druckspannungen in Folge der Behandlung auf der so behandelten Außenseite geringer sind als in der unbehandelten Außenseite.

Ausgehend von einer Außenseite mit den vorstehend beschriebenen nutenfömigen Strukturierungen und einer demgegenüber unbearbeiteten gegenüberliegenden Außenseite führt demnach die Behandlung bei der Strukturierung in Längsrichtung der Haupterstreckung der zu verformenden Struktur bzw. Ausformung zu einer konvexen Verformung und bei der Strukturierung in Querrichtung zu der Haupterstreckung zu einer konkaven Verformung.

Es ist leicht zu verstehen, dass sich nach diesem Prinzip vielfältige Strukturierungsmöglichkeiten ergeben, die sich nicht abschließend aufzählen lassen und die geeignet sind, selbst komplexe 3D-Verformungen in reproduzierbarer Qualität zu realisieren, wobei die Strukturierungen nach individuellen Mustern erzeugt werden können.

Eine solche Strukturierung kann mechanisch oder beispielsweise mittels elektromagnetischer Strahlung, insbesondere eines Lasers, erreicht werden.

Eine Reduzierung einer beispielsweise für den Ionenaustausch nutzbaren Oberfläche bewirkt eine entsprechende Verringerung der Druckspannungen bzw. Zugspannungen, sodass auf diese Weise prinzipiell derselbe Effekt erreicht wird, allerdings ohne die Oberfläche partiell abtragen zu müssen. Vielmehr bleibt die Oberfläche grundsätzlich unverändert erhalten.

Die Abdeckung, unter der beispielsweise eine Schicht zur Passivierung oder Verzögerung der Behandlung zu verstehen ist, kann dauerhaft auf die Oberfläche aufgebracht oder nach der Durchführung der Behandlung wieder entfernt werden, was sich vor allem bei solchen Anwendungen vorteilhaft auswirkt, bei denen die Oberflächenbeschaffenheit möglichst unverändert erhalten werden soll, beispielsweise bei einer Nutzung als Spiegel. Eine solche Abdeckung kann beispielsweise auf die Oberfläche der Struktur aufgedruckt oder als Film aufgebracht werden.

Die Abdeckung kann auch aus einem komplexen, regelmäßigen oder unregelmäßigen Muster bestehen. Alternativ kann auch eine vollflächige Abdeckung aufgetragen werden, die in verschiedenen Bereichen für den Ionenaustausch unterschiedlich durchlässig ist, diesen also mehr oder weniger verzögert.

Selbstverständlich kann auch eine Kombination verschiedener Strukturierungen und/oder Abdeckungen realisiert werden, um so die Effizienz der Verformung weiter zu verbessern. Zudem kann auch die Oberfläche innerhalb der strukturierten Bereiche eine die Behandlung, beispielsweise durch Ionenaustausch begünstigende Oberfläche, beispielsweise eine Mikrostrukturierung oder eine definierte Rauigkeit, aufweisen.

Obwohl die Strukturierung grundsätzlich an der äußeren Oberfläche der Außenseite eingebracht wird, ist es erfindungsgemäß nicht ausgeschlossen, dass durch die Strukturierung eine Modifikation einer tieferliegenden, gegenüber der äußeren Oberfläche beabstandete Schicht ohne eine Veränderung der Oberfläche vorgenommen wird, um so die Behandlung, beispielsweise die Migration der Ionen innerhalb der Struktur zu begünstigen oder zu verzögern.

Die weitere Aufgabe, eine nach diesem Verfahren hergestellte Struktur für mikroelektromechanische Systeme (MEMS) zu schaffen, die insbesondere höchste Anforderungen an die mechanischen Eigenschaften bei zugleich hoher Gestaltungsfreiheit bei der Formgebung erfüllt, wird erfindungsgemäß durch eine Struktur, die zumindest zu einem wesentlichen Teil aus Glas besteht, gelöst, die eine zumindest abschnittsweise unebene, konkav und/oder konvex gebogene Ausformung aufweist. Erfindungsgemäß wird so erstmalig eine gezielte Verformung der Glasstruktur durch das Einbringen lokaler oder partieller Oberflächenspannungen, insbesondere im Verhältnis zu einer gegenüberliegenden, vorzugsweise parallelen Außenseite ermöglicht. Es ist hervorzuheben, dass diese Art der Verformung ohne eine Negativform auskommt, sodass auf diese Weise auch Einzelanfertigungen in wirtschaftlich sinnvoller Weise hergestellt werden können. Zudem können die gewünschten Verformungen auch in solchen Bereichen der Glasstruktur eingebracht werden, die weitgehend unzugänglich innerhalb des Mikroaktuators liegen, sodass neue konstruktive Möglichkeiten bei der Herstellung mikroelektromechanischer Systeme eröffnet werden.

Eine besonders Erfolg versprechende Ausgestaltungsform der Erfindung wird auch dadurch erreicht, dass die konvexe Seite der Ausformung mit einem zumindest abschnittsweise ebenen Element, insbesondere einem Glaselement, einen Spalt mit nicht-linearem Öffnungswinkel einschließt, sodass sich die so geschaffene Struktur optimal zur Herstellung eines elektrostatischen Mikroaktuators eignet. Die konvex gekrümmte Fläche dient dabei als gekrümmte oder gekurvte Elektrode, beispielsweise in Verbindung mit einer flexiblen Glasfeder, die an ihren einander zugewandten Oberflächen mit einer elektrisch leitfähigen Beschichtung versehen sind.

Dabei ist der Spalt mit nicht-linearem Öffnungswinkel nicht durch zwei Geraden begrenzt, sondern zumindest eine Begrenzungslinie folgt zumindest teilweise einer Kurve, wobei auch Sprungstellen nicht ausgeschlossen sind. Der Öffnungswinkel ist dadurch nicht konstant und die Spaltbreite nimmt nicht linear zu. Weiterhin kann die Änderung des Öffnungswinkels, die mathematisch als erste Ableitung der Kurvenfunktion beschrieben werden kann, einem linearen oder einem nicht linearen Verlauf folgen. Somit kann sich die Spaltbreite nicht-linear ändern, wobei der Öffnungswinkel nicht konstant ist.

Eine andere, ebenfalls besonders vorteilhafte Ausführungsform der Erfindung wird auch dadurch erreicht, dass die Ausformung entgegen ihrer elastischen Rückstellkraft in einer verformten Position gegen eine Kontaktfläche anlegbar ist. Aufgrund äußerer Einwirkungen, beispielsweise Krafteinwirkungen oder einer Temperaturänderung, kommt es zu einer elastischen Auslenkung der Ausformung, wodurch die Anlage an der Kontaktfläche unterbrochen wird; beispielsweise kommt es infolge einer thermischen Energiezufuhr aufgrund der metallischen Beschichtung mit einem von dem Glasmaterial abweichenden thermischen Ausdehnungskoeffizienten zu einer Verformung, sodass die Struktur als thermischer Schalter verwendet werden kann.

Die Erfindung lässt verschiedene Ausführungsformen zu. Zur weiteren Verdeutlichung ihres Grundprinzips ist eine davon in de Zeichnung dargestellt und wird nachfolgend beschrieben. Diese zeigt jeweils in einer Prinzipdarstellung in einer Seitenansicht in
- Fig. 1: eine Ausformung einer Struktur mit Längsschnitten in Richtung der Haupterstreckung;
- Fig. 2: die Ausformung mit Schnitten quer zu der Richtung der Haupterstreckung;
- Fig. 3: die Ausformung mit mehreren in Richtung der Haupterstreckung zueinander beabstandeten Abdeckungen;
- Fig. 4: die verformte Ausformung nach einem Ionenaustausch in einer Verwendung als elektrostatischer Mikroaktuator;
- Fig. 5: eine weitere verformte Ausformung in einer Verwendung als thermischer Schalter.

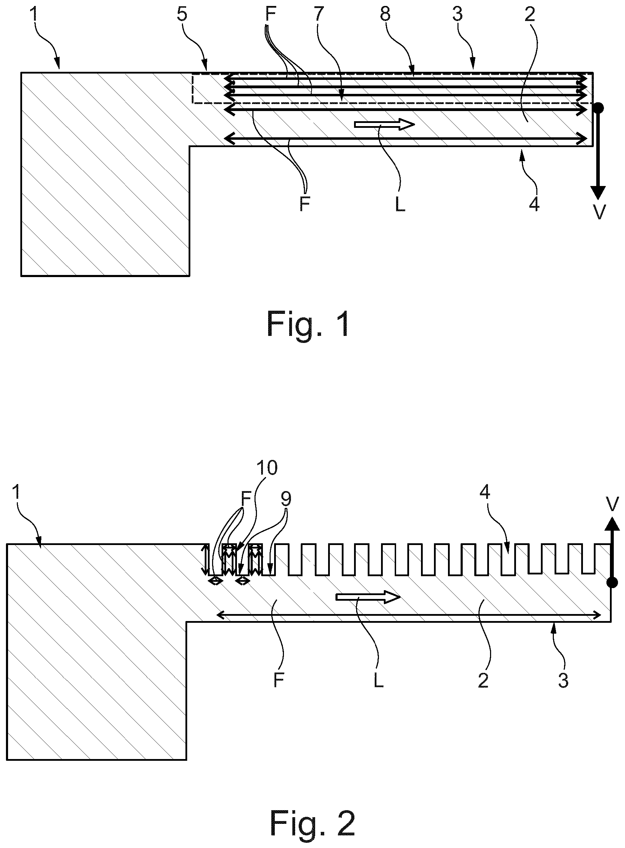

Die Herstellung mikrostrukturierter mechanischer Strukturen 1 aus einem Glassubstrat für die Herstellung mikroelektromechanischer Systeme wird nachstehend anhand der Figuren 1 bis 5 näher erläutert.

Die Struktur 1 hat eine frei auskragende Ausformung 2, die in verschiedenen Anwendungen als bewegliches Element, beispielsweise als Hebel, verwendet wird und hierzu auch nach der irreversiblen Verformung ihre elastische Eigenschaft beibehält.

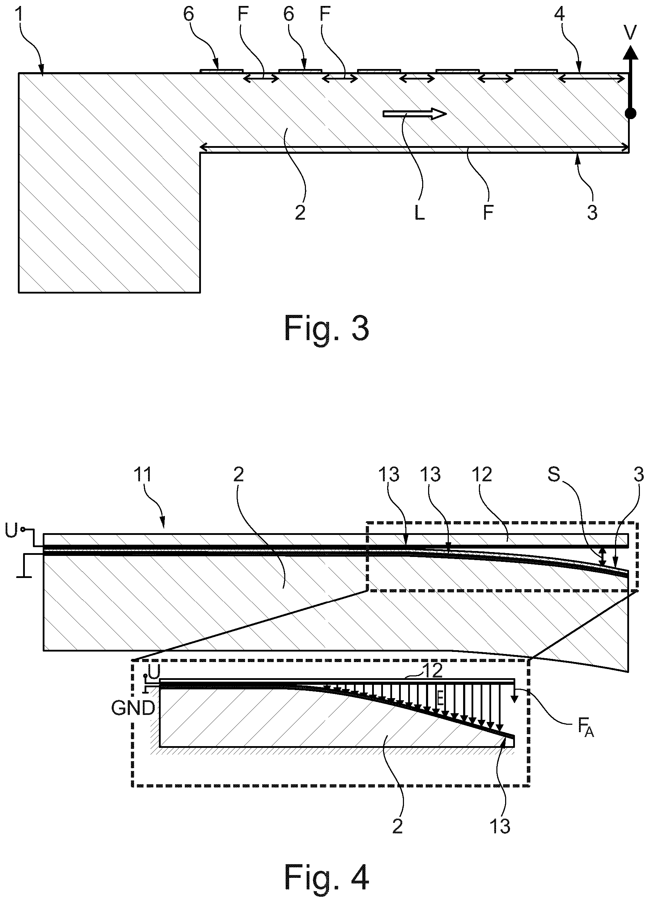

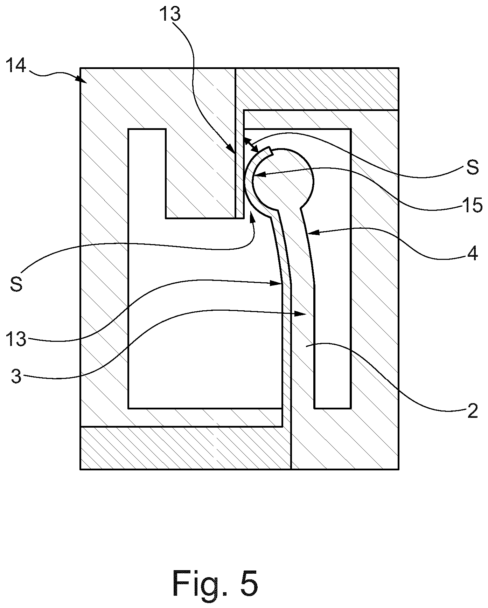

Um eine irreversible Verformung der Ausformung 2 zu erreichen, wird nach dem Prinzip des chemischen Härtens ein Ionenaustausch an beiden gegenüberliegenden Außenseiten 3, 4 vorgenommen, mit einer die konvexe Außenseite 3 bildenden Oberseite und einer die konkave Außenseite 4 bildenden Unterseite der Ausformung, die in den Anwendungsbeispielen der Figuren 4 und 5 erkennbar sind.

Die Erfindung macht sich dabei zu Nutze, dass durch eine geeignete Vorbehandlung vor der Durchführung des lonenaustauschverfahrens der Ionenaustausch an der Oberseite und der Unterseite ungleichmäßig, insbesondere auf der einen Außenseite 4 im geringeren Umfang bzw. nur verzögert erfolgt, sodass die dadurch eingebrachten Druckspannungen F auf den verschiedenen Seiten der Ausformung 2 voneinander abweichen.

Die Vorbehandlung hat zum Ziel, durch eine Strukturierung 5 und/oder durch eine partielle Abdeckung 6 der Oberfläche zumindest an einer Außenseite 3, 4 den Ionenaustausch zu beschleunigen oder zu verzögern, sodass nach Abschluss der Behandlung und der wirkenden ungleichmäßigen Druckspannungen F die Verformung V selbsttätig und nach Art und Umfang der Strukturierung 5 und der Abdeckung 6 einstellbar eintritt.

Nachstehend werden mögliche Strukturierungen 5 und die Abdeckung 6 anhand von drei Varianten lediglich beispielhaft erläutert, wobei darüber hinaus unzählige weitere Möglichkeiten zur Veränderung der Oberfläche denkbar und in der Praxis realisierbar sind. In Figur 1 ist eine Variante gezeigt, bei der die Strukturierung 5 durch eine nutenförmige Vertiefung 7 parallel zu der Haupterstreckungsrichtung L in die Oberseite der Ausformung 2 eingebracht wird, während die Oberfläche an der Unterseite nicht verändert wird. Wesentlich für das Verständnis der Erfindung ist, dass die die nutenförmige Vertiefung 7 begrenzende Wandfläche 8 durch ihre Orientierung parallel zu der Haupterstreckungsrichtung L und die dadurch innerhalb der Wandfläche 8 ebenfalls parallel zu der Haupterstreckungsrichtung L wirkenden Druckspannungen F infolge des Ionenaustauschs nach dem Prinzip der Vektoraddition wirksam zu den insgesamt wirkenden Druckspannungen F beitragen. Die nach dem Ionenaustausch wirkende Verformung V der Ausformung 2 ist durch einen Richtungspfeil angedeutet, sodass sich eine konvexe Außenseite 3 der Ausformung 2 wie in Figur 4 zu erkennen einstellt.

Im Gegensatz dazu führen nutenförmige Vertiefungen 9 mit einer Orientierung quer zu der Haupterstreckungsrichtung L dazu, dass die begrenzenden Wandflächen 10 keinen zusätzlichen Effekt auf die gewünschte Verformung aufweisen. Mehr noch werden die Druckspannungen F in den von den Vertiefungen 9 unterbrochenen Bereichen der ursprünglichen Oberfläche in ihrer Wirkung wesentlich abgeschwächt und führen allenfalls zu einer Verformung V der Wandflächen 10 zwischen den Vertiefungen 9, nicht aber zu einer Verformung V der gesamten Ausformung 2 in Haupterstreckungsrichtung L. Infolge des zugleich an der Unterseite vollflächig erfolgenden Ionenaustauschs und der so eingebrachten Druckspannungen F kommt es zu einer Verformung V der Ausformung 2, deren Richtung wiederum durch einen Richtungspfeil verdeutlich ist, sodass sich eine konkave Außenseite 4 an der Oberseite der Ausformung 2 ergibt.

Eine vergleichbare Reduzierung der in die Oberseite eingebrachten Druckspannungen F hat auch eine in Figur 3 gezeigte partielle Abdeckung 6 durch eine Maskierung der Oberfläche zur Folge. Insbesondere kommt es in den abgedeckten Bereichen nicht oder nur in einem eingeschränkten Umfang zu einem Ionenaustausch, sodass in der Summe die Druckspannungen F an der Oberseite reduziert sind und sich entsprechend dem Richtungspfeil (Verformung V) eine konkave Außenseite 4 der Oberseite der Ausformung 2 ergibt. Durch unterschiedliche Abstände der Abdeckungen 6 kann der Krümmungsradius der Verformung V in Haupterstreckungsrichtung L abschnittsweise unterschiedlich eingestellt werden.

In den Figuren 4 und 5 sind verschiedene Anwendungsmöglichkeiten derart gekrümmter Strukturen 1 dargestellt. Bei einem elektrostatischen Mikroaktuator 11 gemäß Figur 4 schließt die konvexe Außenseite 3 der Ausformung 2 mit einem zumindest abschnittsweise ebenen, flexiblen Glaselement 12 einen Spalt S mit nicht-linearem Öffnungswinkel ein. Die konvex gekrümmte Außenseite 3 dient dabei als gekrümmte oder gekurvte Elektrode in Verbindung mit dem als flexible Glasfeder dienenden Glaselement 12. Die Außenseite 3 sowie die gegenüberliegende Fläche des Glaselements 12 sind an ihren einander zugewandten Oberflächen mit einer elektrisch leitfähigen Beschichtung 13 versehen. Durch Anlegen einer Spannung U entsteht wie dargestellt ein elektrisches Feld E und eine Aktuatorkraft F_{A} normal zu der Oberfläche des Glaselements 12.

In Figur 5 ist eine als thermischer Schalter oder thermischer Sensor ausgeführte MEMS-Struktur 14 in einer Aufsicht dargestellt, wobei die verformte Ausformung 2 gegen eine Kontaktfläche15 anliegt. Eine Änderung der Temperatur führt zu einer elastischen Auslenkung der Ausformung 2, wodurch die Anlage an der Kontaktfläche 15 und damit die elektrische Kontaktierung der metallischen Beschichtungen 13 unterbrochen wird, wobei der Spalt S mit seinem nicht-linearem Öffnungswinkel zwischen der Kontaktfläche 15 und den metallischen Beschichtungen 13 entsteht.

### BEZUGSZEICHENLISTE

- 1: Struktur
- 2: Ausformung
- 3: Außenseite
- 4: Außenseite
- 5: Strukturierung

- 6: Abdeckung
- 7: Vertiefung
- 8: Wandfläche
- 9: Vertiefung
- 10: Wandfläche

- 11: Mikroaktuator
- 12: Glaselement
- 13: Beschichtung
- 14: MEMS-Struktur
- 15: Kontaktfläche

- F: Druckspannung
- L: Haupterstreckungsrichtung
- V: Verformung
- S: Spalt
- E: Elektrisches Feld
- U: Spannung
- F_{A}: Aktuatorkraft

## Patentansprüche

1. Ein zur Herstellung einer Struktur (1) für mikroelektromechanische Systeme (MEMS), insbesondere eines Mikroaktuators (11), bestimmtes Verfahren, bei dem eine insbesondere vorspringende oder auskragende Ausformung (2) der Struktur (1) in oder aus einer Ebene, insbesondere einer Haupterstreckungsebene, zumindest abschnittsweise verformt wird, und dadurch in der Ruheposition der Struktur (1) eine zumindest abschnittsweise ausgelenkte, insbesondere gebogene, gekrümmte und/oder abgewinkelte Form mit einer eine konvexe Außenseite (3) bildenden Oberseite und einer eine konkave Außenseite (4) bildenden Unterseite der Ausformung (2) einnimmt,
wobei das Einnehmen der ausgelenkten Form erfolgt, indem zumindest in eine Außenseite (3, 4) zumindest abschnittsweise eine Strukturierung (5) eingebracht wird und anschließend die Struktur (1) einer Behandlung unterzogen wird, die ein Ionenaustauschverfahren umfasst und durch die in die Struktur in den nicht oder unterschiedlich strukturierten Bereichen Druckspannungen (F) und/oder Zugspannungen in die oberflächennahen Schichten eingebracht werden, sodass durch eine Differenz der Druckspannung (F) und/oder Zugspannung an den verschiedenen Außenseiten (3, 4) der Ausformung (2) die gewünschte Verformung erzeugt wird.

2. Verfahren nach Anspruch 1, **dadurch gekennzeichnet, dass** die Strukturierung (5) mit einer Orientierung zumindest im Wesentlichen parallel zu der Haupterstreckungsrichtung (L) der Ausformung (2) in zumindest eine der Außenseiten (3, 4) eingebracht wird.

3. Verfahren nach Anspruch 1 oder 2, **dadurch gekennzeichnet, dass** zur Strukturierung (5) mehrere insbesondere parallele, nutenförmige Vertiefungen (7, 9), in die zumindest eine Außenseite (3, 4) eingebracht werden.

4. Verfahren nach zumindest einem der vorhergehenden Ansprüche, **dadurch gekennzeichnet, dass** die Strukturierung (5) quer zu der Haupterstreckungsrichtung (L) der Ausformung (2) in die zumindest eine Außenseite (3, 4) eingebracht wird.

5. Verfahren nach zumindest einem der vorhergehenden Ansprüche, **dadurch gekennzeichnet, dass** durch den Abstand der Abdeckungen (6) und/oder die Orientierung der Strukturierung (5) die Stärke der Krümmung der Ausformung (2) eingestellt wird.

6. Struktur (1) für ein mikroelektromechanisches System, hergestellt mit einem Verfahren nach zumindest einem der vorhergehenden Ansprüche, wobei die Struktur (1) eine zumindest abschnittsweise in eine Richtung gebogene Ausformung (2) aufweist, **dadurch gekennzeichnet, dass** die Struktur (1) zumindest zu einem wesentlichen Teil aus Glas besteht.

7. Struktur (1) nach Anspruch 6, **dadurch gekennzeichnet, dass** die konvexe Außenseite (3, 4) der Ausformung (2) mit einem zumindest abschnittsweise ebenen, insbesondere als ein Glaselement (12) ausgeführten Element einen Spalt (S) mit nicht-linearem Öffnungswinkel einschließt.

8. Struktur (1) nach Anspruch 6 oder 7, **dadurch gekennzeichnet, dass** zumindest eine Außenseite (3, 4) der Ausformung (2) zumindest abschnittsweise mit einer elektrisch leitfähigen Beschichtung (13) versehen ist.

9. Struktur (1) nach zumindest einem der Ansprüche 6 bis 8, **dadurch gekennzeichnet, dass** die Ausformung (2) entgegen ihrer elastischen Rückstellkraft in einer verformten Position gegen eine Kontaktfläche (15) anlegbar ist.

## Claims

1. Method for producing a structure (1) for micro-electromechanical systems (MEMS), in particular a microactuator (11), in which an in particular projecting or overhanging formation (2) of the structure (1) is at least partly deformed in or out of a plane, in particular a main plane of extent, and thereby in the rest position of the structure (1) adopts an at least partly deflected, in particular bent, curved and/or angled, shape with an upper side, which forms a convex outer side (3), and an underside, which forms a concave outer side (4), of the formation (2), wherein the deflected shape is adopted by at least partly introducing a structuring (5) at least into one outer side (3, 4) and then subjecting the structure (1) to a treatment which includes an ion-exchange process and introduces compressive stresses (F) and/or tensile stresses in the layers close to the surface into the structure in the unstructured or differently structured regions such that a difference in the compressive stress (F) and/or tensile stress on the various outer sides (3, 4) of the formation (2) generates the desired deformation.

2. Method according to Claim 1, **characterized in that** the structuring (5) is introduced into at least one of the outer sides (3, 4) with an orientation at least substantially parallel to the main direction of extent (L) of the formation (2).

3. Method according to Claim 1 or 2, **characterized in that** a plurality of in particular parallel depressions (7, 9) in the form of grooves are introduced into the at least one outer side (3, 4) for structuring (5) purposes.

4. Method according to at least one of the preceding claims, **characterized in that** the structuring (5) is introduced into the at least one outer side (3, 4) transversely to the main direction of extent (L) of the formation (2).

5. Method according to at least one of the preceding claims, **characterized in that** the degree of curvature of the formation (2) is set by the spacing between the coverings (6) and/or the orientation of the structuring (5).

6. Structure (1) for a micro-electromechanical system, produced by a method according to at least one of the preceding claims, wherein the structure (1) has a formation (2) which is at least partly bent in one direction, **characterized in that** the structure (1) is made at least substantially of glass.

7. Structure (1) according to Claim 6, **characterized in that** the convex outer side (3, 4) of the formation (2), together with an at least partly flat element which in particular is in the form of a glass element (12), forms a gap (S) with a non-linear opening angle.

8. Structure (1) according to Claim 6 or 7, **characterized in that** at least one outer side (3, 4) of the formation (2) is at least partly provided with an electrically conductive coating (13).

9. Structure (1) according to at least one of Claims 6 to 8, **characterized in that**, in a deformed position, the formation (2) can bear against a contact surface (15) counter to its elastic restoring force.

## Revendications

1. Procédé destiné à la fabrication d'une structure (1) pour des systèmes microélectromécaniques (MEMS), notamment d'un microactionneur (11), selon lequel une formation (2) en saillie ou en porte-à-faux de la structure (1) est déformée au moins par sections dans ou à partir d'un plan, notamment d'un plan d'extension principal, et prend ainsi, dans la position de repos de la structure (1), une forme au moins par sections déviée, notamment courbée, incurvée et/ou coudée, avec un coté supérieur formant un côté extérieur convexe (3) et un côté inférieur formant un côté extérieur concave (4) de la formation (2), la prise de la forme déviée s'effectuant en introduisant une structuration (5) au moins par sections dans au moins dans un côté extérieur (3, 4) et en soumettant ensuite la structure (1) à un traitement comprenant un procédé d'échange d'ions et par lequel des contraintes de compression (F) et/ou des contraintes de traction sont introduites dans les couches proches de la surface dans les zones non structurées ou différemment structurées dans la structure, de telle sorte qu'une différence entre la contrainte de compression (F) et/ou la contrainte de traction sur les différents côtés extérieurs (3, 4) de la formation (2) produit la déformation souhaitée.

2. Procédé selon la revendication 1, **caractérisé en ce que** la structuration (5) est introduite avec une orientation au moins essentiellement parallèle à la direction d'extension principale (L) de la formation (2) dans au moins l'un des côtés extérieurs (3, 4).

3. Procédé selon la revendication 1 ou 2, **caractérisé en ce que**, pour la structuration (5), plusieurs renfoncements (7, 9) en formation de rainures, notamment parallèles, sont introduits dans l'au moins un côté extérieur (3, 4).

4. Procédé selon au moins l'une quelconque des revendications précédentes, **caractérisé en ce que** la structuration (5) est introduite transversalement à la direction d'extension principale (L) de la formation (2) dans l'au moins un côté extérieur (3, 4).

5. Procédé selon au moins l'une quelconque des revendications précédentes, **caractérisé en ce que** l'épaisseur de la courbure de la formation (2) est ajustée par l'écart entre les recouvrements (6) et/ou l'orientation de la structuration (5).

6. Structure (1) pour un système microélectromécanique, fabriquée par un procédé selon au moins l'une quelconque des revendications précédentes, la structure (1) présentant une formation (2) courbée au moins par sections dans une direction, **caractérisée en ce que** la structure (1) est constituée au moins en grande partie de verre.

7. Structure (1) selon la revendication 6, **caractérisée en ce que** le côté extérieur convexe (3, 4) de la formation (2) forme avec un élément au moins par sections plat, notamment conçu sous la forme d'un élément en verre (12), une fente (S) avec un angle d'ouverture non linéaire.

8. Structure (1) selon la revendication 6 ou 7, **caractérisée en ce qu'**au moins un côté extérieur (3, 4) de la formation (2) est pourvu, au moins par sections, d'un revêtement électriquement conducteur (13).

9. Structure (1) selon au moins l'une quelconque des revendications 6 à 8, **caractérisée en ce que** la formation (2) peut être appliquée contre une surface de contact (15) dans une position déformée, à l'encontre de sa force de rappel élastique.
